Europäisches Patentamt

European Patent Office

Office européen des brevets

(11) Publication number: **0 397 177**
**A2**

# EUROPEAN PATENT APPLICATION

(21) Application number: 90108831.0

(51) Int. Cl.5: **C09J 7/02**

(22) Date of filing: **10.05.90**

(30) Priority: **11.05.89 JP 116131/89**

(43) Date of publication of application:
**14.11.90 Bulletin 90/46**

(84) Designated Contracting States:
**DE FR GB**

(71) Applicant: **JAPAN GORE-TEX, INC.**
**42-5, 1-chome Akazutsumi**
**Setagaya-ku Tokyo 156(JP)**

(72) Inventor: **Hatakeyama, Minoru**
**1-22, 7-chome, Sakuragaokanishi**
**Sanyo-cho, Akaiwa-gun, Okayama-ken(JP)**
Inventor: **Hazaki, Yoshihito**
**353-1 Shukumo**
**Okayama-City, Okayama-ken(JP)**
Inventor: **Nomi, Haruo**
**15-9, 1-chome, Sakuragaokanishi**
**Sanyo-cho, Akaiwa-gun, Okayama-ken(JP)**

(74) Representative: **Klunker . Schmitt-Nilson .**
**Hirsch**
**Winzererstrasse 106**
**D-8000 München 40(DE)**

(54) **Asymmetric adhesive sheet.**

(57) An adhesive sheet is provided having adhesive layers on both surfaces of a substrate wherein the adhesive layers on both surfaces are asymmetric chemically, physically and/or geometrically. The adhesive sheet is useful in multilayer printed circuit boards.

_Fig.1._

## BACKGROUND OF THE INVENTION

The present invention relates to an adhesive sheet. Specifically, it relates to an adhesive sheet in which the adhesive agent layers that are applied to both sides of the substrate are asymmetric, and which provides good adhesion between different substances to be bonded, which is particularly useful in the adhesion of multilayer printed circuit substrates.

Known multilayer printed circuit boards are comprised of prepreg sandwiched between inner layers of copper covered boards that have been etched to form a circuit, the whole of which is then bonded together. Most of the prepreg presently used is glass cloth that has been impregnated with epoxy resin or the like, with the prepreg being manufactured by immersing the glass cloth in the epoxy resin, lifting it out, and then semi-hardening it (B-staging).

In the prepreg used in conventional adhesive sheets, the adhesive agent layers are formed symmetrically on both sides of the glass cloth used as the substrate. Specifically, the adhesive agents on both sides are chemically identical adhesive agents and have identical characteristics as adhesive agents, such as gel time, with the thickness of the adhesive layers and other factors all being identical. It is natural that these properties should be symmetric in view of the manufacturing method for the prepreg. But the residual rates of the copper in the printed circuits laminated in a multilayer printed circuit are generally not identical, and the thickness of the copper circuits is not necessarily identical. In some cases, the multilayer printed circuits are made up of materials in which the other inner and outer layers which have been laminated with the copper circuits are different from the copper circuits. It is conceivable that copper circuit multilayer boards would be bonded to other substrates, such as a package, or, conversely, some parts could be bonded to the multilayer sheet. In this way, when the materials, configuration (unevenness, etc.) and so forth of the two sides of the material to be bonded by an adhesive sheet that has adhesive agent layers on both sides are different, if the adhesive agent layers on both sides of the adhesive sheet are symmetrical, there can result an inconvenient decrease in adhesion characteristics of the final product, and the like because the adhesion conditions will not be optimal for one or the other of the two sides of the material to be bonded.

The goal of the present invention is to solve the abovementioned problems and provide an adhesive sheet in which an optimized adhesive agent layer is applied to each of the respective sides of the material even if the two sides of the material to be bonded are different.

The present invention offers an adhesive sheet which has adhesive agent layers on both sides of a substrate, the adhesive sheet being characterized by the fact that the adhesive agent layers on both sides are chemically, physically and/or geometrically asymmetrical.

## SUMMARY OF THE INVENTION

An adhesive sheet is provided comprising a substrate having an adhesive layer on both sides thereof wherein the adhesive layers on both sides of the substrate are chemically, physically and/or geometrically asymmetric. One adhesive layer may be an epoxy resin and the other adhesive layer can be selected by the group consisting of polyimide, triazine, cyanic acid ester resins, polybutadiene and fluorine resins. Alternatively, one adhesive layer may be a polyimide resin and the other adhesive layer can be selected from the group consisting of epoxy, triazine, cyanic acid ester resins, polybutadiene and fluorine resins. Still further, one adhesive layer may be a triazine resin and the other adhesive layer can be selected from the group consisting of polyimide, epoxy, cyanic acid ester resins, polybutadiene and fluorine resins, or one adhesive layer may be a cyanic acid ester resin and the other adhesive layer can be selected from the group consisting of polyimide, epoxy, triazine, polybutadiene and fluorine resins or one adhesive layer may be a polybutadiene resin and the other adhesive layer can be selected from the group consisting of polyimide, epoxy, triazine, cyanic acid ester resins and fluorine resins, or one adhesive layer may be a fluorine resin and the other adhesive layer can be selected from the group consisting of polyimide, epoxy, triazine, cyanic acid ester resins and polybutadiene resins. One adhesive layer may be at least 5 micrometers to 200 micrometers thicker than the other adhesive layer.'

EP 0 397 177 A2

## BRIEF DESCRIPTION OF THE DRAWINGS

Fig. 1 is an exploded cross-sectional view of a laminated circuit board wherein a substrate has an adhesive on both of its surfaces, the adhesive on both surfaces being asymmetric with respect to each other.

Fig. 2 is an exploded cross-sectional view of a laminated circuit board having adhesive layers on each surface of a substrate where in the adhesive layers on each surface of the substrate have different thicknesses.

Fig. 3 is a cross-sectional view of another laminated circuit board having adhesive layers on each surface of a substrate where in the adhesive layers on each surface of the substrate have different thicknesses.

Figs. 4 and 5 are cross-sectional views of laminated circuit boards employing adhesive sheets in which the adhesive layers on both sides of the substrate are symmetric.

Fig. 6 is a cross-sectional view of a laminated circuit board employing an adhesive sheet in which the gel times of the adhesive layers on each side of the substrate are different.

## DETAILED DESCRIPTION OF THE INVENTION AND PREFERRED EMBODIMENTS WITH REFERENCE TO THE DRAWINGS

An adhesive sheet is provided having adhesive layers on both surfaces of a substrate wherein the adhesive layers on both surfaces are asymmetric chemically, physically and/or geometrically. The adhesive sheet is useful in multilayer printed circuit boards.

The substrate used in the adhesive sheet of the present invention is not particularly limited, as long as it is in the form of a sheet, and can be any one of a film, a porous film, a woven cloth, a non-woven cloth, and the like. The present invention was completed during investigations into adhesive sheets for use in printed circuit boards, and in this application, fluorine resin substrates can be used favorably because of their low permittivity characteristics. In particular, porous fluorine resin sheets, more specifically, expanded, porous polytetrafluoroethylene (PTFE) sheets, are ideal. Such sheets are disclosed in U.S. Patent 3,953,566. Expanded, porous PTFE sheets and other substrates, including woven cloth, non-woven cloth and porous sheets, are impregnated with resin and can be in a B-stage or a C-stage state, or, they can be used in a state as they are, without impregnating them. The substrate, particularly a synthetic resin, can be one which contains a filler such as ceramic, for example, porous, expanded PTFE containing a filler.

Examples of the above-mentioned kinds of substrates include the following: Porous, expanded PTFE; a fibrous cloth; a sheet or a non-woven cloth of fluorine resin; a porous, expanded PTFE which has been impregnated with a synthetic resin; a porous, expanded PTFE in which has been mixed either an inorganic powder or an inorganic fiber; a porous, expanded PTFE in which has been mixed either an inorganic powder or an inorganic fiber and which has been impregnated with a synthetic resin; or a laminate of a porous, expanded PTFE and one or more resin films such as a polyimide film, a polyether ether ketone film, a polyether sulfone film, a polyester film, and FEP film, or an ETFE film.

The adhesive agent layers formed on both sides of the substrate are either chemically, physically and/or geometrically asymmetrical. Thermally hardened resin adhesive agents are normally used for printed circuit boards, but in principle, thermoplastic resin adhesive agents or other adhesive agents could also be used.

By chemically different adhesive agent layers is meant that the types of adhesive agents are different, and a suitable selection of an adhesive agent would be one with which the user is familiar, taking into consideration such factors as the type of material to be bonded, and selecting from a group consisting of, for example, epoxies, polyimides, triazine, cyanic acid ester resins, polybutadiene and fluorine resins.

Adhesive agent layers which are physically asymmetrical are usually ones in which their characteristics during bonding, such as the gel time, flow, and so forth of the adhesive agent layers are considered, but asymmetry of such characteristics as hardness of the adhesive agent layers after bonding, and flexibility may also be included. For example, when the surface to be bonded is a flat surface, there is no real need to cause the adhesive agent resin to flow, and it is acceptable for the flow of the resin to be low, and for the gel time to be short. Conversely, if the flow is too rapid, or if the gel time is too long, the resin will run out and adhesive strength will decrease. On the other hand, with a surface that is uneven, as in a copper circuit, the resin should be such that its flow and gel time allow it to thoroughly fill the spaces between the circuits. Should the resin not be able to thoroughly fill the spaces between the circuits, voids will be formed that

3

decrease adhesion strength, and the permittivity will result in the deterioration and non-uniformity of the other characteristics.

The adhesive agent layers being geometrically asymmetrical usually signifies that they have different thicknesses. For example, when the surfaces of two copper circuits are bonded together, if one of the copper circuits has a surface with a large residual surface area and one has a surface with a small residual surface area, or if one of the copper circuits has thick conductors and one has thin conductors, then the thickness of the adhesive agent layers, that is, the amount of the adhesive agent layers, should also be different to compensate for the differences in conductor thickness. If the thickness of the adhesive agent layers is not optimized to match the thickness and residual surface area of the copper circuits, the space between the copper circuits will not be thoroughly filled in by the adhesive agent layers, and the resin will not be uniformly present between the circuit surfaces and the substrate, resulting in a drop in adhesion strength, deterioration of product characteristics, and non-uniformity. The difference between the thicknesses of the adhesive agent layers should be at least 5 micrometers, but not more than 200 micrometers.

The adhesive agent layers on both sides of the adhesive sheet of the present invention need not be only chemically, physically or geometrically asymmetric, they may be two or all of these.

The method which forms the adhesive agent layers on the substrate in a non-uniform fashion is not particularly limited. The respective adhesive agent layers may be applied to both sides of the substrate and then altered or, after impregnating the substrate with resin (which works as an adhesive agent), the same or different adhesive agents may then be applied to one or both sides and then altered. Alternatively, a method may be used to change the thickness of the adhesive agent layers on both sides all in one impregnation process.

The thickness of the adhesive agent layer and of the substrate is not particularly limited, but with ordinary adhesive sheets for use in printed circuit boards the substrate preferably is 25 to 200 micrometers thick, most preferably 60 to 100 micrometers, and each of the adhesive agent layers is preferably 5 to 100 micrometers, most preferably 15 to 45 micrometers.

The adhesive sheet of the present invention, in addition to its use in printed circuit boards, can be used, for example, as an adhesive sheet to join a rigid substrate and a flexible substrate, or as an insulating layer between a copper foil and an aluminum base board used as a metallic base substrate.

Because the adhesive sheet of the present invention optimizes each of the adhesive layers formed on both sides of the substrate, depending on materials, configuration, etc. of each of the surfaces of the material to be bonded, it eliminates the inadequacy and inconvenience that arise in conventional adhesive sheets due to the symmetry of both sides of their adhesive agent layers. As a result, it has superior adhesion characteristics and product quality.

Example 1: Adhesive Agent Layers of Different Compositions

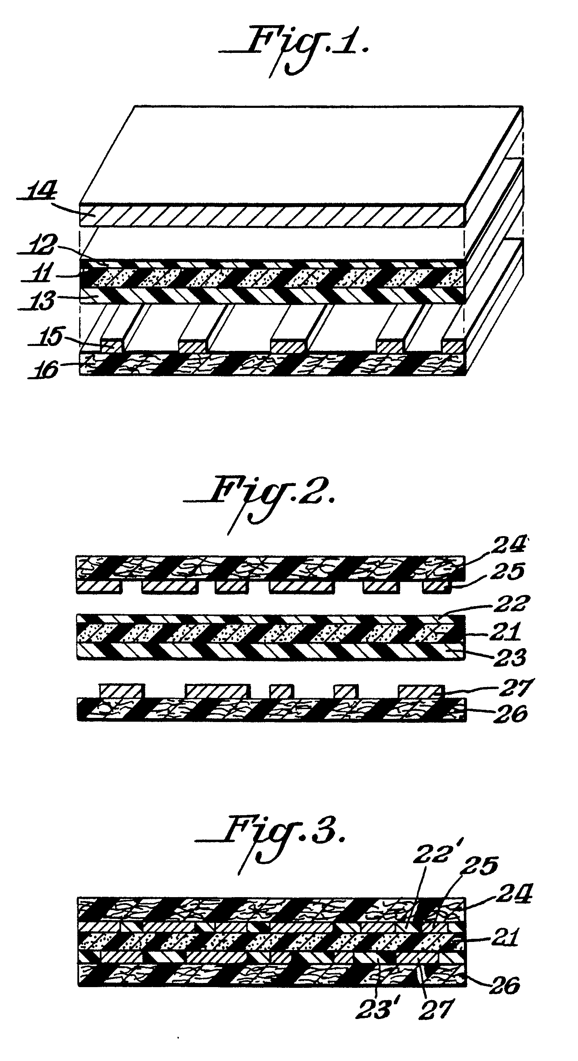

Referring to Fig. 1 , one of the sides of an expanded, porous PTFE sheet 11 (thickness 100 micrometers, porosity 80%, average pore diameter 0.4 micrometers) was coated with a cyanic acid ester resin (BT Resin, made by Mitsubishi Gas and Chemical [Gasu Kagaku]) as the first adhesive agent layer 12 having a coating thickness of 20 micrometers, and the other side was coated with a polyimide resin (Kelimide ®, made by Nippon Polyimide) as the second adhesive agent layer 13 with a coating thickness of 20 micrometers to produce an adhesive sheet according to the invention.

On the first adhesive agent layer 12 side of the adhesive sheet was positioned a 35 micrometer thick copper foil 14, and on the second adhesive agent layer 13 side was positioned a fiberglass coated with polyimide sheet 16, which had a thickness of 100 micrometers, and which had on its surface a copper circuit 15, which was 35 micrometers thick and had a circuit residual surface area of approximately 15%. These were all laminated through thermal compression in a vacuum press.

The tensile peeling strength of the copper foil 14 on the first adhesive agent layer 12 side and the circuited core material 16 on the second adhesive agent layer 13 side of the laminate thus obtained were measured. The results of those measurements are as follows:
First adhesive agent layer side tensile peeling strength = 1.9 kg/cm
Second adhesive agent layer side tensile peeling strength = 1.6 kg/cm

For comparison purposes, a laminated board was manufactured in a manner identical to that above, except that an adhesive sheet was used in which a cyanic acid ester resin or a polyimide identical to those above were applied in thicknesses identical to those above to both sides of an expanded, porous PTFE sheet identical to that above. The results of this construction are as follows:

|  | Tensile Peeling Strength | |
|---|---|---|
| Adhesive Resin | Copper Foil Side | Core Material Side |
| Cyanic acid ester resin (both layers) Polyimide resin (both layers) | 1.9 kg/cm 1.1 kg/cm | 0.8 kg/cm 1.6 kg/cm |

Example 2: Adhesive Agent Layers of Different Thicknesses

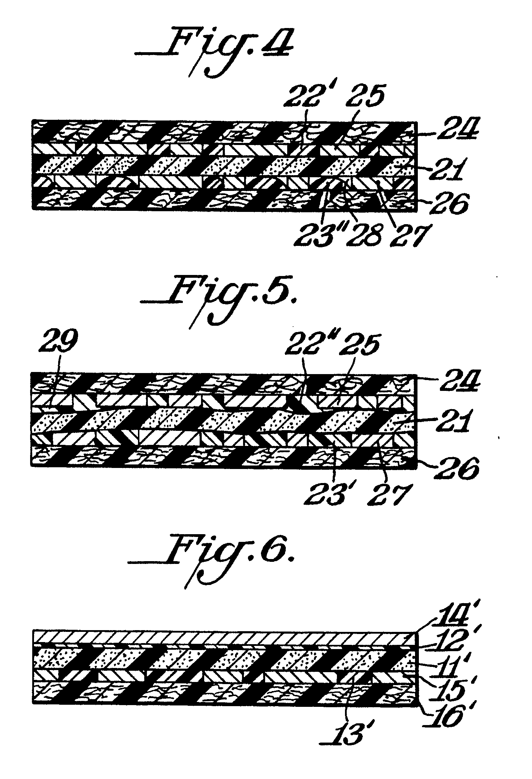

An adhesive sheet was manufactured in the same way as in Fig. 1. In this case, however, as shown in Fig. 2, the adhesive sheet was manufactured as follows: an asymmetric adhesive prepreg was manufactured in which B-staged layers consisting of a polyimide resin layer with a thickness of 15 micrometers (used as the first adhesive layer 22) and a polyimide resin layer with a thickness of 45 micrometers (used as the second adhesive layer 23) were formed on the substrate 21 sheet of expanded, porous PTFE resin which was impregnated with a polyimide resin, which was then converted into a C-stage resin. Using this prepreg, the glass/polyimide core material 24, which had on its surface to be bonded a copper foil 25, which was 50 micrometers thick and had a residual surface area of 90%, was positioned on the first adhesive agent layer 22 side of the adhesive sheet 14. On the second adhesive agent layer 23 side was positioned the glass/polyimide core material 26, which had on its surface to be bonded a copper foil 27, which was 50 micrometers thick and had a residual surface area of 50%.

Upon cutting this multilayer board and examining its interior, the adhesive agent resins 22' and 23' were completely filled in between the copper foil circuits 25 and 27 on both sides of the substrate 21, with no voids, and no swelling when tested for soldering heat resistance (260°, one hour) . There was no resin remaining non-uniformly between the circuit surface and the substrate, the interlayer thickness was extremely uniformly laminated, and the characteristic impedance was stabilized.

By regulating the thickness of the adhesive agent layers on both sides of this kind of adhesive sheet to match the uneven configuration of the surface of the material to be bonded, the amount of excess resin that exudes out around the multilayer boards during the lamination stage is small, and there will be very little resin spattering on the laminated boards or the press and lamination supports.

For comparison purposes, referring to Fig. 4, both the first and second adhesive agent layers were laminated as above with a layer thickness of 15 micrometers. Voids 28 were formed, particularly on the second adhesive agent layer side between the copper foil and the circuit, and swelling resulted from the soldering heat resistance test.

In addition, referring to Fig. 5, both the first and second adhesive agent layers were laminated as above with a layer thickness of 45 micrometers. The second adhesive agent layer was laminated uniformly, but excess resin exuded out around the laminated board, and the flowing resin generated a force which pushed the copper foil circuit towards the outside, resulting in a loss of dimensional stability. As can be seen in Fig. 5, the resin 29 exuded between the copper foil circuit and the substrate, which decreased the permittivity and made the characteristic impedance unstable.

Example 3: Adhesive Agent Layers are Physically Different

Referring to Fig. 1, the configuration of this laminated board is the same as that in Fig. 1, i.e., an expanded, porous PTFE, used as a substrate, was impregnated with an epoxy resin, and using this in a B-stage state, an asymmetric adhesive prepreg was produced, the first adhesive agent layer being a B-stage epoxy resin that had a thickness of 20 micrometers and a gel time of 60 seconds, and the second adhesive agent layer being a B-stage epoxy resin that had a thickness of 20 micrometers and a gel time of 180 seconds.

On the first adhesive agent layer side was positioned a copper foil, and on the second adhesive agent layer side was positioned a sheet of glass/epoxy core material which had on its surface to be bonded a copper foil circuit with a thickness of 50 micrometers and a residual surface area of 40%, and these were then laminated through thermal compression on a vacuum press to produce a laminated board.

Upon cutting this multilayer board and examining its interior, as can be seen in Fig. 6, on the first adhesive agent layer side, the adhesive agent resin 12' adequately formed a layer between the copper foil 14' and the substrate 11' . And on the second adhesive agent layer side, the adhesive agent resin 13' uniformly filled the space between the copper foil 15' and the substrate 11' . There was very little resin exuding around the laminated board, and no resin spattering of the laminated board, the press or the lamination supports.

For comparison purposes, when the gel times of both the first and second adhesive agent layers were set at 60 seconds, the resin did not adequately fill in the circuit on the second adhesive layer side, and voids were formed. And when the gel times of both the first and second adhesive agent layers were set at 180 seconds, the resin on the first adhesive agent side exuded out in large quantities, the peeling strength between the copper foil and the substrate went down, and the resin which exuded out in large quantities spattered the laminated board, the press and the lamination supports.

With the present invention, when the materials to be bonded are of different materials, i.e., surface configuration, unevenness, etc., since an adhesive sheet is used which is an optimum adhesive agent layer for each of the surfaces, adhesion is possible and there is little or no poor adhesion, voids, deterioration of product quality, non-uniformity, or other such drawbacks. Most importantly, the adhesive sheet of the present invention is useful as an adhesive prepreg for multilayer circuit boards, and, in particular, is ideal for this purpose when at least a part of the substrate is expanded, porous PTFE.

While the invention has been disclosed herein in connection with certain embodiments and detailed descriptions, it will be clear to one skilled in the art that modifications or variations of such details can be made without deviating from the gist of this invention, and such modifications or variations are considered to be within the scope of the claims hereinbelow.

## Claims

1. An adhesive sheet comprising a substrate having an adhesive layer on both sides thereof wherein said adhesive layers on both sides of said substrate are chemically and/or geometrically and/or physically asymmetric.

2. The adhesive sheet of claim 1 wherein the adhesive layers on both sides are of different materials, each selected from the group of epoxy resins polyimide, triazine, cyanic acid ester resins, polybutadiene and fluorine resins.

3. The adhesive sheet of claims 1 or 2 wherein one said adhesive layer is at least 5 micrometers to 200 micrometers thicker than the other adhesive layer.

*Fig.1.*

*Fig.2.*

*Fig.3.*

Fig.4

Fig.5.

Fig.6.